(19) **Europäisches Patentamt / European Patent Office / Office européen des brevets**

(11) **EP 4 339 703 A1**

(12) # EUROPEAN PATENT APPLICATION

(43) Date of publication:
**20.03.2024 Bulletin 2024/12**

(21) Application number: **22195453.0**

(22) Date of filing: **13.09.2022**

(51) International Patent Classification (IPC):
**G03F 7/20** (2006.01)

(52) Cooperative Patent Classification (CPC):
**G03F 7/70616; G03F 7/705**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventor: **TINNEMANS, Patricius, Aloysius Jacobus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY METHOD AND ASSOCIATED METROLOGY DEVICE**

(57) Disclosed is a dark-field metrology method. A first partial electric field is determined from a measurement parameter of first diffracted radiation data relating to a first portion of a diffraction order and a second partial electric field is determined from a measurement parameter of second diffracted radiation data relating to a second portion of the diffraction order, The first portion of the diffraction order and second portion of the diffraction order relate to respective portions of a detection pupil plane or conjugate thereof. An electric field of said diffraction order is determined from said first partial electric field and said second partial electric field.

Fig. 7

**Description**

FIELD

The present invention relates to a metrology method and device which may, for example, be used for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as CD = $k_1 \times \lambda$/NA, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

In many metrology applications, it is desirable to access the full electric field (i.e., intensity and phase) rather than only intensity. Holography tools enable this, however they require a reference beam and very stringent operation to ensure interference between the reference beam and measurement radiation beam. Other phase retrieval methods may comprise an iterative retrieval of phase, however these are computationally demanding,

It would be desirable to improve on present methods for measuring the full electric field in metrology applications.

SUMMARY

Embodiments of the invention are disclosed in the claims and in the detailed description.

In a first aspect of the invention there is provided a dark-field metrology method comprising: obtaining at least first diffracted radiation data and second diffracted radiation data, said first diffracted radiation data relating to a first portion of a diffraction order, and said second diffracted radiation data relating to a second portion of the diffraction order, wherein said first portion of the diffraction order and second portion of the diffraction order relate to respective portions of a detection pupil plane or conjugate thereof; determining a first partial electric field from a measurement parameter of said first diffracted radiation data; determining a second partial electric field from a measurement parameter of said second diffracted radiation data; and determining an electric field of said diffraction order from said first partial electric field and said second partial electric field.

In a second aspect of the invention there is provided a dark-field metrology device, comprising: an illumination arrangement for illuminating a structure on a substrate so as to generate at least one diffraction order; a detection arrangement for detecting said at least one diffraction order or a portion thereof; a spatial filter arrangement in a detection pupil plane or conjugate thereof of the dark-field metrology device, the spatial filter arrangement being operable to separately transmit at least a first portion of the diffraction order and a second portion of the diffraction order such that they are separately detected on the detection arrangement; and a processor operable to: determine a first partial electric field from a measurement parameter of first diffracted radiation data relating to the first portion of the diffraction order; determine a second partial electric field from a measurement parameter of second diffracted radiation data relating to said the second portion of a diffraction order; and determine an electric field of said diffraction order from at least said first partial electric field and said second partial electric field.

These and other aspects and advantages of the apparatus and methods disclosed herein will be appreciated from a consideration of the following description and drawings of exemplary embodiments.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 is a schematic illustration of a scatterometry apparatus;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements (d) a third pair of illumination apertures combining the first and second pair of apertures;
- Figure 6 is a schematic illustration of a one-dimensional coordinate system relevant to concepts disclosed herein;
- Figure 7(a) is a schematic illustration of a metrology arrangement according to an embodiment, (b) a first mask for performing a metrology method according to an embodiment and (c) a complementary second mask for performing the metrology method;
- Figure 8 is a flowchart describing a metrology method according to an embodiment; and
- Figure 9 depicts a block diagram of a computer system for controlling a metrology method and/or device such as disclosed herein.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

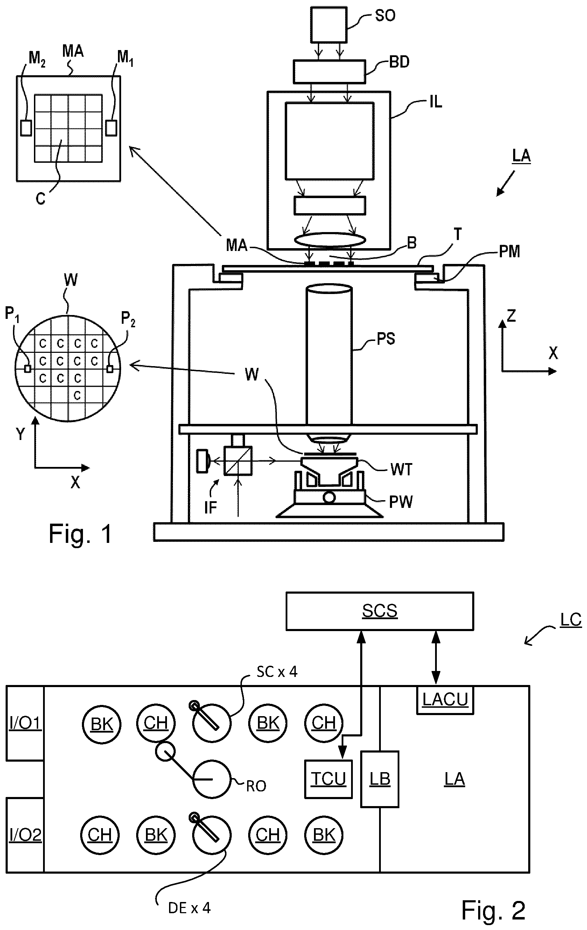

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the maskMA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

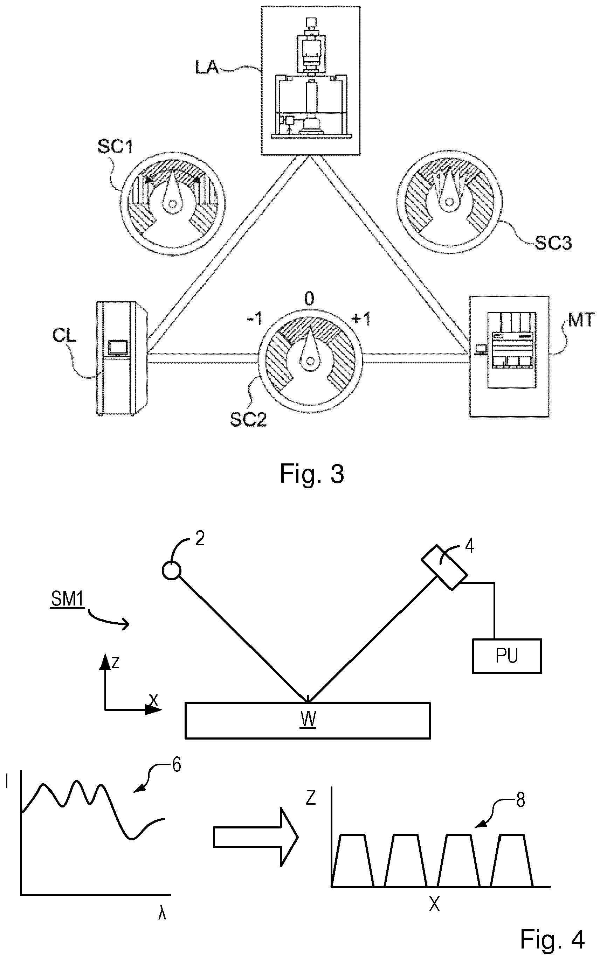

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Figure 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers ca measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety. Other parameters of interest may be focus and dose. Focus and dose may be determined simultaneously by scatterometry (or alternatively by scanning electron microscopy) as described in US patent application US2011-0249244, incorporated herein by reference in its entirety.

The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

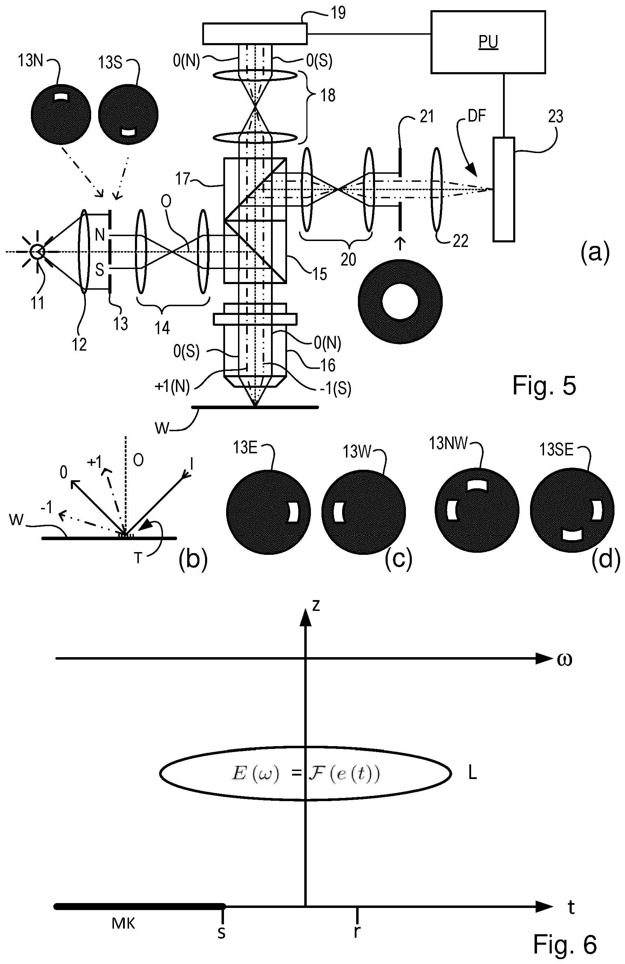

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., axenon lamp) is directed onto substrate W via a beam splitter 15 by an optical system comprising lenses 12, 11 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 11, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 5(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

As an alternative to a scatterometer, a metrology device may comprise a holographic microscope such as a digital holographic microscope (DHM) or digital dark-field holographic microscope. Such as device is disclosed, for example, in US2019/0107781 and WO2021121733A1 both of which is incorporated herein by reference.

In a scatterometry metrology tool, light may be used to create an image (e.g., at one or both of an image plane or pupil plane) of a structure on a substrate. Such tools may measure the intensity or amplitude (or related measurement parameter such as diffraction efficiency) of the detected light, e.g., after having been scattered by the structure, and use this to determine one or more parameters of interest of the structure. In many cases, it may be beneficial to know the complex field (i.e., amplitude and phase) of the light scattered by the structure.

There are a number of present methods which enable the phase to be determined, in addition to the measured intensity/amplitude. One such technology is the aforementioned DHM, however holographic methods are typically subject to strict stability requirements and/or very low acquisition times, to suppress mechanical vibrations and/or drift and therefore achieve the necessary interference of the scattered radiation with reference radiation at the detector.

Another known method comprises performing multiple measurements under various conditions (e.g., different focus levels) and reconstructing the complex field of the scattered light using an iterative algorithm (e.g. as described in WO2021/121733, incorporated herein by reference). However, such methods are computationally very demanding/expensive and can be slow as a consequence, particularly as the accuracy of the retrieved phase is required to be higher in metrology than for more conventional phase retrieval applications such as microscopy and which require only the formation of an image. Other technologies are also known such as using masks having a pinhole or similar aperture in the detection branch of the tool, which allows an interferometric measurement (e.g. as described in WO2020/254041, incorporated herein by reference).

A non-iterative method for determining the complex field of the scattered radiation will now be described, based on causality, such as which applies in the (one-dimensional) time versus angular frequency context. This time causality stems from the fact that the electric field cannot travel faster than the speed of light, leading to an electric field $E=0$ for a time $t<0$ constraint. This time/causality constraint leads to a symmetry relationship of the electric field in the angular frequency domain. This symmetry relation is often referred to as the Kramers-Kronig relationship (and its inverse, which is the second Kramers-Kronig relationship).

The proposed method is based on an optical analogy of this concept. The time constraint is replaced/implemented by locating a mask in the pupil plane, such that the time coordinate $t$ becomes the pupil coordinate, and the

angular frequency coordinate $\omega$ becomes the sensor/camera (image plane) coordinate. Because the Kramers-Kronig relationship comprises a linear integral transform (in essence a convolution operation), the (one-dimensional) Kramers-Kronig expression(s), expressed in terms of Fourier transforms, may be extended into a two-dimensional analysis; i.e., the two dimensions of the pupil plane/image plane.

As an extension, it is also possible to further extend the analysis into three dimensions. In such a three dimensional extension, in addition to the two optical pupil/spatial coordinates, the further dimension may be wavelength, such that the method may determine the complex field from images measured for multiple individual illumination wavelengths. Such a three dimensional Kramers-Kronig embodiment provides a physical model that couples the spatial and through-wavelength behavior, which may be an advantage, for example for one or more of: suppressing measurement noise, interpolating the data, providing a key performance indicator (KPI) to guard data consistency.

In the following discussion, the following definition of the Fourier transform $\mathcal{F}$ of function $g(t)$ will be used:

$$
\begin{aligned}
\mathcal{G}(\omega) &= \mathcal{F}\big(g(t)\big) \\
&= \int_{-\infty}^{+\infty} g(t) e^{i\omega t}\, \mathrm{d}t
\end{aligned}
$$

and the inverse Fourier transform $\mathcal{F}^{-1}$ of function $\mathcal{G}(\omega)$ will be:

$$
\begin{aligned}
g(t) &= \mathcal{F}^{-1}\big(\mathcal{G}(\omega)\big) \\
&= \frac{1}{2\pi} \int_{-\infty}^{+\infty} \mathcal{G}(\omega) e^{-i\omega t}\, \mathrm{d}\omega
\end{aligned}
$$

where $i$ denotes the imaginary unit number, $\omega$ denotes the sensor/image plane position (analogous to radial frequency in conventional Kramers-Kronig analysis, hence the use of the symbol $\omega$) and $t$ denotes the pupil plane position (analogous to time in conventional Kramers-Kronig analysis, hence the use of the symbol $t$).

Figure 6 illustrates a coordinate system for illustrating one-dimensional complex field retrieval, on which the following analysis will be based. Shown is the sensor plane $\omega$, the pupil plane $t$, lens or free-space L, the Fourier transform symmetry axis $z$, a masked region MK within pupil plane $t$ having a mask edge at $t=s$. The location $t=r$ denotes the location of the origin of function $g(t)$ in the pupil plane. While the choice of $t$ symmetry shifts $r$ and $s$ can hitherto be made arbitrarily, more typically it will be chosen that $r=s$, i.e., the mask edge is located at the origin of function $g(t)$.

It is initially chosen that:

$$
\mathcal{G}(\omega) = e^{(-i(r-s)\omega)\log(E(\omega))}
$$

where $E(\omega)$ is the electric field at the sensor and $e(t) = \mathcal{F}^{-1}\big(E(\omega)\big)$ is the electric field at the pupil. It may be further defined that $E(\omega) \neq 0$ to prevent $\log(E(\omega))$ taking on a value of $-\infty$. It may also be further defined that $-\pi < \arg(E(\omega)) < \pi$ to avoid $\log(E(\omega))$ from unwinding the phase.

Fourier transforming the $t$ symmetry restriction $g(t-r) = 0$ for $t < s$ and inserting the above logarithmic expansion yields:

$$
\mathcal{F}^{-1}\big(e^{is\omega} \log(E(\omega))\big) = 0 \text{ for } t < s
$$

This $t$ restriction forces the logarithmic expansion to satisfy $t$ symmetry, enabling insertion of the logarithmic expansion into $\omega$ symmetry. Based on this, it can be shown that the electric field $E(\omega)$ can be constructed from only its modulus (i.e., measured image amplitude or square root of the measured image intensity), as, ignoring a global phase offset which is not of interest, the electric field may be described by:

$$E(\omega) = e^{\left(\mathcal{F}\left((1+\mathrm{sgn}(t))\mathcal{F}^{-1}(\log(|E(\omega)|))\right)\right)} \qquad Eq\ (1);$$

$$\mathrm{sgn}(t) = \begin{cases} -1 & \text{if } t < 0 \\ 0 & \text{if } t = 0 \\ 1 & \text{if } t > 0 \end{cases}$$

assuming that $t$ restriction $e(t - r) = 0$, for $t < r$ and a sufficient convergence condition are satisfied. This $t$ restriction is an alternative to that recited above, which has an advantage of being implementable via a hardware mask or equivalent arrangement.

A sufficient convergence condition may be: $\left|1 - \frac{E(\omega)}{E_0}\right| < 1$ , where $E_0$ is a freely definable non-zero complex constant. The convergence condition stems from the expansion of the real logarithm function (of the electric field) via a power series, used in the derivation of this definition of electric field $E(\omega)$ recited in Equation Eq (1). This power series expansion has a limited convergence region/domain. It may be that this convergence condition can be relaxed in some instances.

Of course, a measured image will typically comprise a two-dimensional image. Given the linearity and separability of the two-dimensional Fourier transform, the one-dimensional field retrieval relationship can be adapted to two-dimensions, by replacing the one-dimensional Fourier transforms by two-dimensional Fourier transforms, and by appropriately aligning the $t$ symmetry via rotation angle $\theta$ (i.e. aligning with respect to the applied pupil mask). This yields the two-dimensional field retrieval relation.

$$E\left(\omega_x, \omega_y\right) = e^{\left(\mathcal{F}\left((1+\mathrm{sgn}(\cos(\theta)\,t_x + \sin(\theta)\,t_y))\mathcal{F}^{-1}(\log(|E(\omega_x,\omega_y)|))\right)\right)} \qquad Eq\ (2)$$

As such, a field retrieval method may comprise performing a partial or masked field retrieval from each of respective measured field moduli (amplitudes), each measured field modulus being obtained from a respective partial (e.g., masked) measurements of two (or more) partial measurements, each partial measurement relating to a respective portion of the field of interest (e.g., a respective portion of a diffraction order from the structure of interest). This step may use Equation Eq (2) for example. Each partial field can then be combined together; e.g., the partial fields may be summed together, given the linearity of the electric field.

This may be simplest achieved by performing a first measurement of a first portion (e.g., first half) of the diffraction order/field of interest, e.g., by masking the second portion/half of the diffraction order at a (detection) pupil plane or conjugate thereof and detecting the resultant image. This can then be repeated for the second portion/half of the diffraction order, with the first half masked. The two partial electric fields can be determined from these measurements by calculation using the measured electric field moduli from the images; these masked electric fields can then be summed to determine the full unmasked electric field. The $t$ restriction may be satisfied by ensuring that the mask edge for each mask is located at the electric field origin (e.g., it passes through the center of the diffraction order in the relevant direction)

As such, disclosed herein is a dark-field metrology method comprising: obtaining at least first diffracted radiation data and second diffracted radiation data, said first diffracted radiation data relating to a first portion of a diffraction order, and said second diffracted radiation data relating to a second portion of the diffraction order, wherein said first portion of the diffraction order and second portion of the diffraction order relate to respective portions of a detection pupil plane or conjugate thereof; determining a first partial electric field from a measurement parameter (e.g., amplitude) of said first diffracted radiation data; determining a second partial electric field from a measurement parameter (e.g., amplitude) of said second diffracted radiation data; and determining an electric field of said diffraction order from said first partial electric field and said second partial electric field.

Also disclosed is a dark-field metrology device, comprising: an illumination arrangement for illuminating a structure on a substrate so as to generate at least one diffraction order; a detection arrangement for detecting said at least one diffraction order or a portion thereof; a spatial filter arrangement in a detection pupil plane or conjugate thereof of the dark-field metrology device, the spatial filter arrangement being operable to separately transmit at least a first portion of the diffraction order and a second portion of the diffraction order such that they are separately detected on the detection arrangement; and a processor operable to: determine a first partial electric field from a measurement parameter (e.g., amplitude) of first diffracted radiation data relating to the first portion of the diffraction order; determine a second partial electric field from a measurement parameter (e.g., amplitude) of second diffracted radiation data relating to said the second portion of a diffraction order; and determine an electric field of said diffraction order from at least said first partial electric field and said second partial electric field.

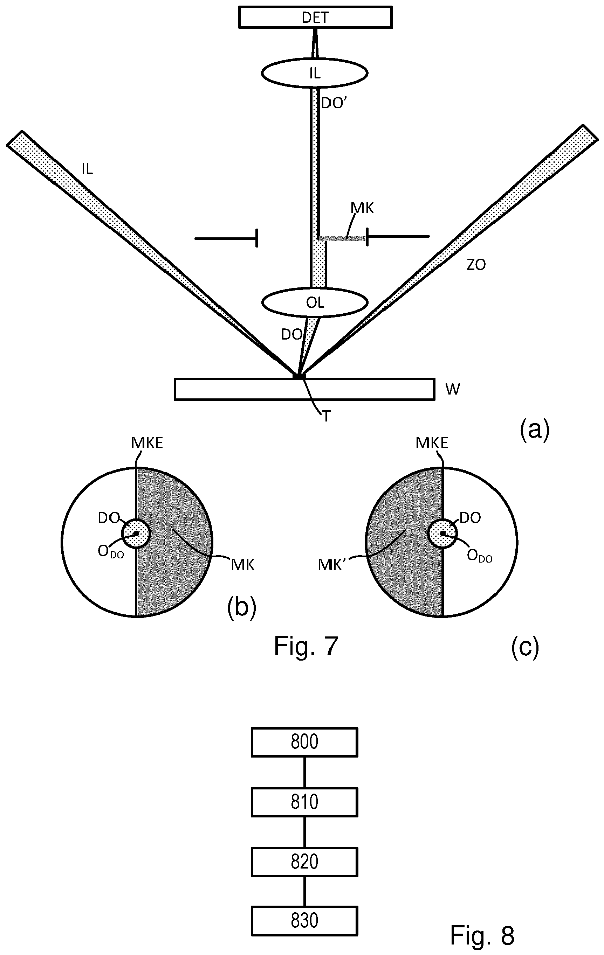

Figure 7(a) schematically illustrates a measurement arrangement for performing such as masked measurement. It shows an illumination beam IL incident on a target T on substrate W, generating a zeroth order (specular) beam ZO and first order diffracted beam DO. The first order diffracted beam DO is collected by an objective lens OL. In a pupil plane, a mask MK blocks (typically) half of the diffraction order. The remaining part of the diffracted order DO' is imaged via a lens IL onto a detector DET. Figure 7(b) shows the detection optics pupil mask MK covering half of the detection NA. Such a mask may be used for $\theta = 0°$, e.g., such that the origin $O_{DO}$ of diffraction order DO is properly aligned with the mask edge MKE. Figure 7(c) shows the corresponding detection mask MK' for a complementary measurement of the diffraction order. The measurements using each detection mask MK, MK' can then be combined as described.

While spatial filter masks are described above for portioning the pupil, other spatial filtering arrangements may be used to do this instead. It will be appreciated that, while Figure 7 shows the pupil portioned into masked and unmasked halves and the diffraction order origin centered on the mask edge, the arrangement is shown in this way for illustration convenience. In reality, the position of the diffraction order in pupil space will be dependent on the illumination wavelength and pitch (i.e. periodicity) of the target. As such, a single pair of complementary (fixed) masks will only allow measurements for one wavelength/pitch ratio. This can be addressed by providing multiple fixed masks (e.g., on a wheel or other arrangement) which may be switched into the detection path depending on wavelength and/or pitch. Improved configurability and flexibility may be achieved using a configurable filter arrangement such as a spatial light modulator or knife-edge aperture which can be configured according to wavelength/pitch.

The spatial filter masks, or more specifically the apertures provided by such masks may be complementary in that the pupil space defined by the mask apertures do not overlap. However, this is not essential and the overlap can be handled mathematically, e.g., via subtraction or multiplication of the fields/intensities.

Other alternative spatial filtering arrangements may comprise beam diverting optics such as mirrors or wedges (e.g., a mirror or wedge for each half or portion of the diffraction order). This enables simultaneous imaging of both portions of the diffraction order on different parts of the detector or different detectors. Configurable mirror arrays (e.g., digital micro-mirror device or similar) may be used to enable such simultaneous imaging with configurability for different wavelengths/pitches. This may also be achieved by providing for a programmable shift of mirrors or wedges to track any wavelength and/or pitch changes.

In special circumstances, the mask can be located on the edge of the detection pupil, such that the origin of the electric field passes via the pupil edge (e.g., is located on this edge). In this case, one of the two images from respective complementary masked measurements has been described will have zero intensity. In such an embodiment, the measurement corresponding to the zero intensity image does not actually need to be performed, as its intensity can be assumed zero (as can its associated partial electric field). In such an embodiment, only first diffracted radiation data is required, e.g., related to a first portion of a diffraction order (another portion of this diffraction order will not be captured by the detection NA as it has an origin on the NA boundary). The step of obtaining second diffracted radiation data may comprise estimating the second diffracted radiation data to be zero and the step of determining a second partial electric field may comprise determining this as zero based on the estimation.

In a three-dimensional implementation, as described above, multiple masks or suitably configured SLM or DMD may be used to mask the diffraction order of each wavelength individually. As such, the two-dimensional measurement described above may be repeated for more than one illumination wavelength. Extending the Kramers-Kronig teaching from one dimension to two was done by exploiting the linearity of the transforms. When adding the third dimension (e.g., measurement wavelength) the same can be done, but now the dimensions are measurement wavelength and time, with the speed of light restriction (i.e., it cannot be exceeded) located in the time domain. Therefore the three-dimensional implementation is effectively the same construct as the two-dimensional implementation, except now three dimensional Fourier transforms are applied and the rotation by $\theta$ does not rotate in this third added (wavelength) dimension.

So to summarize, the electric fields in equation (2) become three dimensional. The Fourier transform and its inverse also becomes three dimensional, and the three-dimensional field retrieval relation can be recited as:

$$E\left(\omega_x, \omega_y, \omega_\lambda\right) = e^{\left(\mathcal{F}\left(\left(1 + \operatorname{sgn}\left(\cos(\theta)\, t_x + \sin(\theta)\, t_y + t_\lambda\right)\right)\mathcal{F}^{-1}\left(\log\left(\left|E(\omega_x, \omega_y, \omega_\lambda)\right|\right)\right)\right)\right)} \qquad Eq\ (3)$$

where the $\lambda$ subscript relates to this third dimension.

While the examples show two halves of the field of interest being measured separately, this is not a requirement. The method may comprise separating the field of interest (e.g., measured diffraction order) into three or more portions and treating these in the manner described to determine respective partial fields, which can then be combined into the full field. The portions may also be of different (e.g., irregular) shapes and/or sizes provided that the *t* restriction is observed. The portions do not need to include or cover all of the diffraction order; in such a case this would amount to an effective reduction in the detection numerical aperture (NA). The portions may comprise non-overlapping portions, although as already said, this is not necessary and overlapping portions may be handled computationally.

Such a method enables full field measurement without the need for a reference beam, thereby supporting long acquisition times, due to lower opto-mechanical stability requirements. This is further achieved without the need of an iterative phase retrieval algorithm needed, with its accompanying (typical) slow convergence speed and/or high computational cost.

For (digital) holography, the self-interference and cross-interference terms are required to be separable in the pupil domain such that one of the two cross-interference terms can be cropped out and an (inverse) Fourier transform can be applied to recover the whole complex electric field. Such separation is (usually) achieved by adjusting the reference wave incidence angle(s). The phase determination as described herein relaxes this restriction, as it only requires the diffraction orders (ideally) not to overlap, to recover the complex field.

The proposed method requires only a small number of acquisitions. Typically only two acquisitions (one for each of the two adjacent masks) are required in a sequential scheme, and only a single acquisition is required if both images are measured in parallel (for example by implementing the adjacent masking functionality via mirrors or prisms).

The proposed method may be performed relatively to a reference target. In fact, because of the linearity of the resulting non-iterative phase retrieval relation, a similar non-iterative phase retrieval relationship as disclosed herein may be applied to a combination (e.g., the ratio) of two electric fields, e.g., the ratio of the diffracted order electric field of interest and a reference electric field (resulting from the reference target). If the reference electric field is close to the measured electric field, then it is (more) likely that their ratio will satisfy the relevant convergence condition. In the one-dimensional version, this field ratio may be determined as:

$$\frac{E(\omega)}{E_{ref}(\omega)} = e^{\left(\mathcal{F}\left((1+\text{sgn}(t))\mathcal{F}^{-1}\left(\log\left(\frac{|E(\omega)|}{|E_{ref}(\omega)|}\right)\right)\right)\right)} \qquad Eq\ (4)$$

where $E_{ref}(\omega)$ is the reference electric field. The two-dimension equivalent may be:

$$\frac{E(\omega_x, \omega_y)}{E_{ref}(\omega_x, \omega_y)} = e^{\left(\mathcal{F}\left((1+\text{sgn}(\cos(\theta)\,t_x+\sin(\theta)\,t_y))\mathcal{F}^{-1}\left(\log\left(\frac{|E(\omega_x,\omega_y)|}{|E_{ref}(\omega_x,\omega_y)|}\right)\right)\right)\right)} \qquad Eq\ (5)$$

As such, determining a first partial electric field may comprise determining a combination (e.g., ratio) of the first partial electric field and the reference electric field (e.g., a first partial electric field in this context may comprise such a relative electric field described by such a combination or ratio) from an amplitude of the first portion of the diffraction order and an amplitude of the reference radiation; and said determining a second partial electric field comprises determining a combination of the second partial electric field and the reference electric field (e.g., a second partial electric field in this context may comprise such a relative electric field described by such a combination or ratio) from the amplitude of the second portion of the diffraction order and the amplitude of the reference radiation. Such a method may of course include measuring the target and reference target to obtain the partial electric fields and reference electric field.

Note that, as an alternative to the ratio of two electric fields, the related parameter may comprise a product of the measured electric field with the conjugated reference electric field. This product will have the same phase (but not amplitude) as the ratio of the measured and reference electric field. The relative retrieval expressions Eq (4) and Eq (5) enable the use of a reference, which can be used to address the phase winding issue by using a reference with a wound phase profile comparable/close to that of the target being measured. Also note that the electric field retrieval expressions derived have a slight advantage over equivalent phase retrieval expressions as they partially address the (potential) phase wrapping problem.

The algorithm as proposed computes at the sensor plane (i.e., where the image intensity is measured). At the sensor plane, the numerical aperture is typically low, due to the large optical magnification required to match the camera pixel size to the metrology target dimensions and illumination wavelength combination. This low numerical aperture is an advantage as it simplifies/enables a full vectorial electric-field phase retrieval, as opposed to only a scalar electric-field phase retrieval.

The methods proposed herein may enable a finite bandwidth (i.e., partial spectral coherence) and/or (some) partial spatial coherence to be handled, as this will result in an average phase, or an average relative phase of the target, to be measured. Such an average may be a weighted average, the weights of which may depend on the measurement conditions.

Only a few and simple optics are needed to implement the concepts disclosed herein, typically only two masks or equivalent, which enables phase measurements for soft X-ray (SXR) wavelengths, assuming a dark-field imaging detection optics configuration. In this context, SXR wavelengths may comprise wavelengths within the range 0.1nm to 100nm, 0.1nm to 50nm, 1nm to 50nm, 1nm to 30nm, 5nm to 30nm, or 10nm to 20nm.

The proposed methods disclosed here enable (computational) access to a field plane, which allows for a suppression of the metrology target environment via a computational masking/apodization.

The proposed methods disclosed here may be beneficial for profilometry, as it provides additional information, for example to address multiple scattering in the metrology target and its surroundings.

Figure 8 is a flowchart of a proposed method according to an exemplary embodiment. At step 800, a target is measured and diffraction order captured by an objective lens. A mask or other spatial modulation arrangement is located in a pupil plane, which blocks (for example) a first half (in terms of pupil area) of the diffraction order such that only a second half of the diffraction order is detected on a detector. The edge of the mask may be located at the electric field origin of the diffraction order.

At step 810, the target may be measured again with a complementary mask or other spatial modulation arrangement which blocks (for example) the second half (in terms of pupil area) of the diffraction order such that only first half of the diffraction order is detected on a detector. Steps 800 and 810 may be combined into a single acquisition, e.g., using wedges or mirrors for simultaneous imaging.

The detected intensity values of each detected image from steps 800 and 810 may be converted at step 820 to an amplitude (e.g., by square root), and this used to determine the partial electric field for each respective half of the diffraction order using, for example, Equation Eq (2) or (e.g., where multiple wavelengths are used) Eq (3) or ( e.g., where a reference target is used) the relative partial electric field using Equation Eq (5).

At step 830, the partial electric fields may be combined, e.g., summed to obtain the full electric field description for the diffraction order.

Steps 800 to 830 may be performed, for example, for each of a pair of complementary diffraction orders from the target (e.g., the +1 and -1 diffraction orders, although higher order pairs may be used). A parameter of interest can then be determined from a difference or imbalance in the measured fields (amplitude and/or phase) from the respective diffraction orders of the pair of diffraction orders. The parameter of interest may comprise, for example, overlay, focus or edge placement error depending on target type. The measurement technique proposed is a dark-field measurement, such that the zeroth order beam is either blocked or diverted to another part of the detector (or other detector) for separate analysis. The method may be performed simultaneously on each diffraction order of the pair of diffraction orders (e.g., the +1 and -1 diffraction orders simultaneously), e.g., where each of these diffraction orders are imaged simultaneously (in time, but separated in space). Such arrangements are known (e.g., which use optical wedges or mirrors to divert the diffraction orders to respective different portions of the detector or different detectors) and are described in many of the documents cited above.

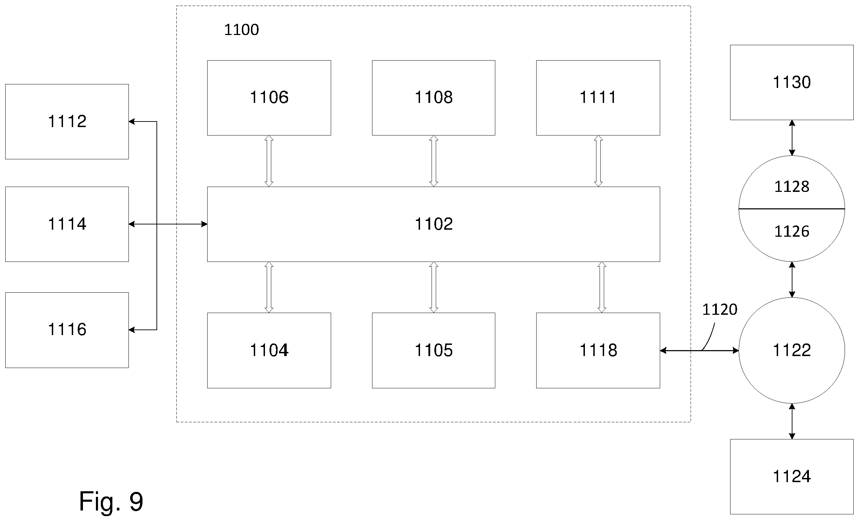

Figure 9 is a block diagram that illustrates a computer system 1100 that may assist in implementing the methods and flows disclosed herein. Computer system 1100 includes a bus 1102 or other communication mechanism for communicating information, and a processor 1104 (or multiple processors 1104 and 1105) coupled with bus 1102 for processing information. Computer system 1100 also includes a main memory 1106, such as a random access memory (RAM) or other dynamic storage device, coupled to bus 1102 for storing information and instructions to be executed by processor 1104. Main memory 1106 also may be used for storing temporary variables or other intermediate information during execution of instructions to be executed by processor 1104. Computer system 1100 further includes a read only memory (ROM) 1108 or other static storage device coupled to bus 1102 for storing static information and instructions for processor 1104. A storage device 1110, such as a magnetic disk or optical disk, is provided and coupled to bus 1102 for storing information and instructions.

Computer system 1100 may be coupled via bus 1102 to a display 1112, such as a cathode ray tube (CRT) or flat panel or touch panel display for displaying information to a computer user. An input device 1114, including alphanumeric and other keys, is coupled to bus 1102 for communicating information and command selections to processor 1104. Another type of user input device is cursor control 1116, such as a mouse, a trackball, or cursor direction keys for communicating direction information and command selections to processor 1104 and for controlling cursor movement on display 1112. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 1100 in response to processor 1104 executing one or more sequences of one or more instructions contained in main memory 1106. Such instructions may be read into main memory 1106 from another computer-readable medium, such as storage device 1110. Execution of the sequences of instructions contained in main memory 1106 causes processor 1104 to perform the process steps described herein. One or more processors in a multi-processing arrangement may also be employed to execute the sequences of instructions contained in main memory 1106. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 1104 for execution. Such a medium may take many forms, including but not limited to, non-volatile media, volatile media, and transmission media. Non-volatile media include, for example, optical or magnetic disks, such as storage device 1110. Volatile media include dynamic memory, such as main memory 1106. Transmission media include coaxial cables, copper wire and fiber optics, including the wires that comprise bus 1102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 1104 for execution. For example, the instructions may initially be borne on a magnetic disk of a remote computer. The remote computer can load the instructions into its dynamic memory and send the instructions over a telephone line using a modem. A modem local to computer system 1100 can receive the data on the telephone line and use an infrared transmitter to convert the data to an infrared signal. An infrared detector coupled to bus 1102 can receive the data carried in the infrared signal and place the data on bus 1102. Bus 1102 carries the data to main memory 1106, from which processor 1104 retrieves and executes the instructions. The instructions received by main memory 1106 may optionally be stored on storage device 1110 either before or after execution by processor 1104.

Computer system 1100 also preferably includes a communication interface 1118 coupled to bus 1102. Communication interface 1118 provides a two-way data communication coupling to a network link 1120 that is connected to a local network 1122. For example, communication interface 1118 may be an integrated services digital network (ISDN) card or a modem to provide a data communication connection to a corresponding type of telephone line. As another example, communication interface 1118 may be a local area network (LAN) card to provide a data communication connection to a compatible LAN. Wireless links may also be implemented. In any such implementation, communication interface 1118 sends and receives electrical, electromagnetic or optical signals that carry digital data streams representing various types of information.

Network link 1120 typically provides data communication through one or more networks to other data devices. For example, network link 1120 may provide a connection through local network 1122 to a host computer 1124 or to data equipment operated by an Internet Service Provider (ISP) 1126. ISP 1126 in turn provides data communication services through the worldwide packet data communication network, now commonly referred to as the "Internet" 1128. Local network 1122 and Internet 1128 both use electrical, electromagnetic or optical signals that carry digital data streams. The signals through the various networks and the signals on network link 1120 and through communication interface 1118, which carry the digital data to and from computer system 1100, are exemplary forms of carrier waves transporting the information.

Computer system 1100 may send messages and receive data, including program code, through the network(s), network link 1120, and communication interface 1118. In the Internet example, a server 1130 might transmit a requested code for an application program through Internet 1128, ISP 1126, local network 1122 and communication interface 1118. One such downloaded application may provide for one or more of the techniques described herein, for example. The received code may be executed by processor 1104 as it is received, and/or stored in storage device 1110, or other non-volatile storage for later execution. In this manner, computer system 1100 may obtain application code in the form of a carrier wave.

Additional embodiments are disclosed in the subsequent list of numbered clauses:

1. A dark-field metrology method comprising:

obtaining at least first diffracted radiation data and second diffracted radiation data, said first diffracted radiation data relating to a first portion of a diffraction order, and said second diffracted radiation data relating to a second portion of the diffraction order, wherein said first portion of the diffraction order and second portion of the diffraction order relate to respective portions of a detection pupil plane or conjugate thereof;
determining a first partial electric field from a measurement parameter of said first diffracted radiation data;
determining a second partial electric field from a measurement parameter of said second diffracted radiation data; and
determining an electric field of said diffraction order from said first partial electric field and said second partial electric field.

2. A dark-field metrology method as defined in clause 1, wherein said field is determined as a function of each of two dimensions of a detection plane at which said first portion of the diffraction order and said second portion of the diffraction order are detected.

3. A dark-field metrology method as defined in clause 2, wherein said first diffracted radiation data and said second diffracted radiation data each comprise two dimensional data relating to said two dimensions of the detection plane.

4. A dark-field metrology method as defined in clause 2 or 3, wherein said field is determined additionally as a function of a third dimension.

5. A dark-field metrology method as defined in clause 4, wherein said third dimension relates to wavelength of the diffraction order.

6. A dark-field metrology method as defined in any preceding clause, wherein said first portion of the diffraction order and said second portion of the diffraction order comprise portions on either side of an origin of said diffraction order.

7. A dark-field metrology method as defined in any preceding clause, wherein said first diffracted radiation data and said second diffracted radiation data each comprise intensity data and the method comprises converting said intensity data to said measurement parameter of said first diffracted radiation data and said measurement parameter of said second diffracted radiation data, in each case said measurement parameter comprising amplitude.

8. A dark-field metrology method as defined in any preceding clause, comprising determining a parameter of interest from said determined electric field.

9. A method as defined in clause 8, wherein said parameter of interest is overlay, focus or edge placement error.

10. A dark-field metrology method as defined in any preceding clause, wherein said determining an electric field comprises summing together said first partial electric field and said second partial electric field.

11. A dark-field metrology method as defined in any preceding clause, wherein said first diffracted radiation data and second diffracted radiation data relate to a measurement of a structure on a substrate.

12. A dark-field metrology method as defined in clause 11, further comprising obtaining reference radiation data relating to reference radiation related to measurement of a reference structure; wherein:

said determining a first partial electric field comprises determining a combination of said first partial electric field and a reference electric field of said reference radiation from a measurement parameter of said first diffracted radiation data and a measurement parameter of the reference radiation; and

said determining a second partial electric field comprises determining a combination of said second partial electric field and said reference electric field from the measurement parameter of said second diffracted radiation data and the measurement parameter of the reference radiation.

13. A dark field metrology method as defined in any preceding clause, wherein said step of obtaining said second diffracted radiation data comprises estimating said second diffracted radiation data to be zero, and said step of determining a second partial electric field and/or related parameter comprises determining said second partial electric field and/or related parameter to be zero.

14. A dark field metrology method as defined in any preceding clause, comprising illuminating a structure on a substrate to obtain said diffraction order; and

spatially filtering and/or spatially separating said diffraction order at said detection pupil plane to obtain said first portion of the diffraction order and said second portion of the diffraction order.

15. A dark-field metrology method as defined in any of clauses 1 to 12, comprising illuminating a structure on a substrate to obtain said diffraction order.

16. A dark-field metrology method as defined in clause 15, comprising:

spatially filtering and/or spatially separating said diffraction order at said detection pupil plane to obtain said first portion of the diffraction order and said second portion of the diffraction order; and

separately detecting said first portion of the diffraction order and said second portion of the diffraction order to obtain said first diffracted radiation data and said second diffracted radiation data.

17. A dark-field metrology method as defined in clause 16, comprising simultaneously measuring said first portion of the diffraction order and said second portion of the diffraction order.

18. A dark-field metrology method as defined in clause 17, comprising using beam diverting optics to divert said first portion of the diffraction order and said second portion of the diffraction order to be separately detected.

19. A dark-field metrology method as defined in clause 16, comprising sequentially measuring said first portion of the diffraction order and said second portion of the diffraction order.

20. A dark-field metrology method as defined in clause 19, comprising spatially filtering each of said first portion of the diffraction order and said second portion of the diffraction order using respective complementary spatial filters.

21. A dark-field metrology method as defined in clause 19, comprising configuring a spatial light modulator for each of said first portion of the diffraction order and said second portion of the diffraction order.

22. A dark-field metrology method as defined in clause 14 or any of clauses 16 to 22, where the spatial filtering comprises an apodization in the pupil plane.

23. A dark-field metrology method as defined in any of clauses 14 to 22, comprising using soft-X-ray wavelength illumination to illuminate said structure.

24. A computer program comprising program instructions operable to perform the method of any of clauses 1 to 13, when run on a suitable apparatus.

25. A non-transient computer program carrier comprising the computer program of clause 24.

26. A processing arrangement comprising:

a computer program carrier comprising the computer program of clause 25; and
a processor operable to run said computer program.

27. A dark-field metrology device being operable to perform the method of any of clauses 14 to 23.

28. A dark-field metrology device, comprising:

an illumination arrangement for illuminating a structure on a substrate so as to generate at least one diffraction order;
a detection arrangement for detecting said at least one diffraction order or a portion thereof;
a spatial filter arrangement in a detection pupil plane or conjugate thereof of the dark-field metrology device, the spatial filter arrangement being operable to separately transmit at least a first portion of the diffraction order and a second portion of the diffraction order such that they are separately detected on the detection arrangement; and
a processor operable to:

determine a first partial electric field and/or related parameter from a measurement parameter of first diffracted radiation data relating to the first portion of the diffraction order;
determine a second partial electric field and/or related parameter from a measurement parameter of second diffracted radiation data relating to said the second portion of a diffraction order; and
determine an electric field of said diffraction order from at least said first partial electric field and said second partial electric field.

29. A dark-field metrology device as defined in clause 28, wherein said processor is operable to determine said electric field as a function of each of two dimensions of a detection plane at which said first portion of the diffraction order and said second portion of the diffraction order are detected.

30. A dark-field metrology device as defined in clause 29, wherein said first diffracted radiation data and said second diffracted radiation data each comprise two dimensional data relating to said two dimensions of the detection plane.

31. A dark-field metrology device as defined in clause 29 or 30, wherein said processor is operable to determine said electric field as a function of a third dimension.

32. A dark-field metrology device as defined in clause 31, wherein said third dimension relates to wavelength of the diffraction order.

33. A dark-field metrology device as defined in any of clauses 28 to 32, wherein an edge of said spatial filter arrangement is located, within said detection pupil plane or conjugate thereof, on an origin of said diffraction order.

34. A dark-field metrology device as defined in any of clauses 28 to 33, wherein said first diffracted radiation data and said second diffracted radiation data each comprise intensity data and the processor is operable to convert said intensity data to said measurement parameter of said first diffracted radiation data and said measurement parameter of said second diffracted radiation data, said measurement parameter in each case comprising amplitude.

35. A dark-field metrology device as defined in any of clauses 28 to 34, the processor is operable to determine a parameter of interest from said determined electric field.

36. A dark-field metrology device as defined in clause 35, wherein said parameter of interest is overlay, focus or edge placement error.

37. A dark-field metrology device as defined in any of clauses 28 to 36, wherein said processor is operable to determine the electric field by summing together said first partial electric field and said second partial electric field.

38. A dark-field metrology device as defined in any of clauses 28 to 37, wherein said spatial filter arrangement comprises beam diverting optics to divert said first portion of the diffraction order to said first portion of the detection arrangement and said second portion of the diffraction order to a second portion of the detection arrangement.

39. A dark-field metrology device as defined in clause 38, wherein said beam diverting optics comprise one or both of mirrors or optical wedges.

40. A dark-field metrology device as defined in clause 38 or 39, wherein said beam diverting optics comprise a digital micromirror device.

41. A dark-field metrology device as defined in any of clauses 28 to 37, wherein said spatial filter arrangement is operable to sequentially transmit only one of said first portion of the diffraction order and said second portion of the diffraction order.

42. A dark-field metrology device as defined in clause 41, wherein the spatial filter arrangement comprises at least two complementary masks.

43. A dark-field metrology device as defined in clause 41, wherein the spatial filter arrangement comprises a configurable aperture or spatial light modulator.

44. A dark-field metrology device as defined in any of clauses 28 to 43; wherein said processor is operable to:

> determine said first partial electric field as a combination of said first partial electric field and a reference electric field of reference radiation from a measurement parameter of said first diffracted radiation data and a measurement parameter of the reference radiation, the reference radiation relating to a measurement of a reference structure; and
> determine said second partial electric field as a combination of said second partial electric field and said reference electric field from the measurement parameter of said second diffracted radiation data and the measurement parameter of the reference radiation.

45. A dark-field metrology device as defined in any of clauses 28 to 44, where the spatial filter arrangement is operable to perform an apodization in the pupil plane.

46. A dark-field metrology device as defined in any of clauses 28 to 45, wherein said illumination arrangement is operable to generate soft-X-ray wavelength illumination.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A dark-field metrology device, comprising:

   an illumination arrangement for illuminating a structure on a substrate so as to generate at least one diffraction order;
   a detection arrangement for detecting said at least one diffraction order or a portion thereof;
   a spatial filter arrangement in a detection pupil plane or conjugate thereof of the dark-field metrology device, the spatial filter arrangement being operable to separately transmit at least a first portion of the diffraction order and a second portion of the diffraction order such that they are separately detected on the detection arrangement; and
   a processor operable to:

      determine a first partial electric field from a measurement parameter of first diffracted radiation data relating to the first portion of the diffraction order;
      determine a second partial electric field from a measurement parameter of second diffracted radiation data relating to said the second portion of a diffraction order; and
      determine an electric field of said diffraction order from at least said first partial electric field and said second partial electric field.

2. A dark-field metrology device as claimed in claim 1, wherein said processor is operable to determine said electric field as a function of each of two dimensions of a detection plane at which said first portion of the diffraction order and said second portion of the diffraction order are detected.

3. A dark-field metrology device as claimed in claim 2, wherein said first diffracted radiation data and said second diffracted radiation data each comprise two dimensional data relating to said two dimensions of the detection plane.

4. A dark-field metrology device as claimed in claim 2 or 3, wherein said processor is operable to determine said electric field as a function of a third dimension.

5. A dark-field metrology device as claimed in claim 4, wherein said third dimension relates to wavelength of the diffraction order.

6. A dark-field metrology device as claimed in any of claims 1 to 5, wherein an edge of said spatial filter arrangement is located, within said detection pupil plane or conjugate thereof, on an origin of said diffraction order.

7. A dark-field metrology device as claimed in any of claims 1 to 6, wherein said first diffracted radiation data and said second diffracted radiation data each comprise intensity data and the processor is operable to convert said intensity data to said measurement parameter of said first diffracted radiation data and said measurement parameter of said second diffracted radiation data, said measurement parameter in each case comprising amplitude.

8. A dark-field metrology device as claimed in any of claims 1 to 7, the processor is operable to determine a parameter of interest from said determined electric field.

9. A dark-field metrology device as claimed in claim 8, wherein said parameter of interest is overlay, focus or edge placement error.

10. A dark-field metrology device as claimed in any of claims 1 to 9, wherein said processor is operable to determine the electric field by summing together said first partial electric field and said second partial electric field.

11. A dark-field metrology device as claimed in any of claims 1 to 10, wherein said spatial filter arrangement comprises beam diverting optics to divert said first portion of the diffraction order to said first portion of the detection arrangement and said second portion of the diffraction order to a second portion of the detection arrangement.

12. A dark-field metrology device as claimed in claim 11, wherein said beam diverting optics comprise one or both of mirrors or optical wedges, and, optionally, said beam diverting optics comprise a digital micromirror device.

13. A dark-field metrology device as claimed in any of claims 1 to 10, wherein said spatial filter arrangement is operable to sequentially transmit only one of said first portion of the diffraction order and said second portion of the diffraction order, and, optionally, one of i) the spatial filter arrangement comprises at least two complementary masks, and ii)the spatial filter arrangement comprises a configurable aperture or spatial light modulator.

14. A dark-field metrology method comprising:

obtaining at least first diffracted radiation data and second diffracted radiation data, said first diffracted radiation data relating to a first portion of a diffraction order, and said second diffracted radiation data relating to a second portion of the diffraction order, wherein said first portion of the diffraction order and second portion of the diffraction order relate to respective portions of a detection pupil plane or conjugate thereof;
determining a first partial electric field from a measurement parameter of said first diffracted radiation data;
determining a second partial electric field from a measurement parameter of said second diffracted radiation data; and
determining an electric field of said diffraction order from said first partial electric field and said second partial electric field.

15. A computer program comprising program instructions operable to perform the method of claim 14, when run on a suitable apparatus.

Fig. 1

Fig. 2

LA

SC1

SC3

CL

0
-1        +1

SC2

MT

## Fig. 3

SM1

2

4

PU

Z
X

W

I

6

λ

Z

8

X

## Fig. 4

Fig. 5

$$E(\omega) = \mathcal{F}(e(t))$$

Fig. 6

DET

IL

DO'

IL

MK

ZO

OL

DO

W

T

(a)

MKE

DO

O$_{DO}$

MK

(b)

MKE

DO

O$_{DO}$

MK'

(c)

Fig. 7

800

810

820

830

Fig. 8

Fig. 9

Europäisches
Patentamt

European
Patent Office

Office européen
des brevets

## EUROPEAN SEARCH REPORT

Application Number

EP 22 19 5453

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2021/121733 A1 (ASML NETHERLANDS BV [NL]; STICHTING VU [NL] ET AL.) 24 June 2021 (2021-06-24) | 14,15 | INV. G03F7/20 |
| A | * abstract * <br> * figures 11-14 * <br> * paragraphs [0002], [0089] - [0141] * | 1-13 | |
| A | US 2017/292918 A1 (KOLCHIN PAVEL [US] ET AL) 12 October 2017 (2017-10-12) <br> * abstract * <br> * figures 1-6 * <br> * paragraphs [0001], [0050] - [0059] * | 1-15 | |
| A | HANGWEN LU ET AL: "Quantitative phase imaging and complex field reconstruction by pupil modulation differential phase contrast", OPTICS EXPRESS, vol. 24, no. 22, 31 October 2016 (2016-10-31), page 25345, XP055444512, US ISSN: 2161-2072, DOI: 10.1364/OE.24.025345 * the whole document * | 1-15 | |
| A | CHENG SHEN ET AL: "Non-iterative complex wave-field reconstruction based on Kramers-Kronig relations", ARXIV.ORG, CORNELL UNIVERSITY LIBRARY, 201 OLIN LIBRARY CORNELL UNIVERSITY ITHACA, NY 14853, 11 May 2020 (2020-05-11), XP081989005, DOI: 10.1364/PRJ.419886 * the whole document * | 1-15 | |

TECHNICAL FIELDS
SEARCHED (IPC)

G03F

The present search report has been drawn up for all claims

| Place of search | Date of completion of the search | Examiner |
|---|---|---|
| Munich | 27 February 2023 | Andersen, Ole |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                                              

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 22 19 5453**

This annex lists the patent family members relating to the patent documents cited in the above-mentioned European search report.
The members are as contained in the European Patent Office EDP file on
The European Patent Office is in no way liable for these particulars which are merely given for the purpose of information.

**27-02-2023**

| Patent document cited in search report | | Publication date | Patent family member(s) | | Publication date |
|---|---|---|---|---|---|
| WO 2021121733 | A1 | 24-06-2021 | CN | 114830043 A | 29-07-2022 |
| | | | IL | 293746 A | 01-08-2022 |
| | | | JP | 2023506946 A | 20-02-2023 |
| | | | KR | 20220101695 A | 19-07-2022 |
| | | | TW | 202129430 A | 01-08-2021 |
| | | | US | 2023044632 A1 | 09-02-2023 |
| | | | WO | 2021121733 A1 | 24-06-2021 |
| US 2017292918 | A1 | 12-10-2017 | CN | 106415249 A | 15-02-2017 |
| | | | CN | 108508028 A | 07-09-2018 |
| | | | JP | 6652511 B2 | 26-02-2020 |
| | | | JP | 2017527780 A | 21-09-2017 |
| | | | KR | 20170021830 A | 28-02-2017 |
| | | | US | 2015377797 A1 | 31-12-2015 |
| | | | US | 2017292918 A1 | 12-10-2017 |
| | | | WO | 2015200856 A1 | 30-12-2015 |

EPO FORM P0459

For more details about this annex : see Official Journal of the European Patent Office, No. 12/82

**REFERENCES CITED IN THE DESCRIPTION**

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 20190107781 A
- WO 2021121733 A1
- WO 2021121733 A
- WO 2020254041 A